## Europäisches Patentamt

## European Patent Office

## Office européen des brevets

(19)

(11) Veröffentlichungsnummer: **0 080 659**
**B1**

(12) # EUROPÄISCHE PATENTSCHRIFT

(45) Veröffentlichungstag der Patentschrift:
08.04.87

(51) Int. Cl.⁴: **G 03 D 3/08,** G 03 D 3/10

(21) Anmeldenummer: **82110660.6**

(22) Anmeldetag: **18.11.82**

(54) Verarbeitungsgerät für bildmässig belichtete fotoempfindliche Materialien.

(30) Priorität: **27.11.81 DE 3147002**

(43) Veröffentlichungstag der Anmeldung:
**08.06.83 Patentblatt 83/23**

(45) Bekanntmachung des Hinweises auf die Patenterteilung:
**08.04.87 Patentblatt 87/15**

(84) Benannte Vertragsstaaten:
**DE FR GB**

(56) Entgegenhaltungen:
**DE-A-1 522 893**
**DE-A-2 238 414**
**DE-A-2 529 290**
**DE-A-2 809 056**
**DE-B-1 263 507**
**DE-B-1 296 521**
**FR-A-1 602 201**
**GB-A-1 276 383**
**GB-A-1 465 813**
**US-A-2 981 171**

(73) Patentinhaber: **HOECHST AKTIENGESELLSCHAFT,
Postfach 80 03 20, D-6230 Frankfurt am Main 80
(DE)**

(72) Erfinder: **Schörnig, Eberhard, Römerstrasse 9,
D-6204 Taunusstein 4 (DE)**

## Beschreibung

Die Erfindung betrifft ein Verarbeitungsgerät für bildmäßig belichtete fotoempfindliche Materialien, insbesondere Druckplatten, mit zumindest zwei Behandlungszonen, in denen herausnehmbare Wanneneinsätze vorhanden sind, die Transport- und Führungseinrichtungen zum kontinuierlichen bogen- und geradlinigen Führen des Materials durch die Behandlungszonen enthalten sowie in der ersten Behandlungszone eine Entwicklungseinrichtung mit einer Abdeckung, die zum Teil in die Behandlungsflüssigkeit hineinragt.

Ein derartiges Gerät ist aus dem deutschen Gebrauchsmuster G 80 28 682 bekannt.

Aus der FR-A 1.602.201 ist ein Entwicklungsgerät bekannt, das Transportrollen und Führungsplatten aufweist, die das belichtete Material sowohl bogenförmig als auch geradlinig durch das Gerätegehäuse hindurchführen. Die Behandlung des Materials geschieht durch bogenmäßige Führung in einem Tauchbad, wobei nur eine einseitige Bearbeitung des belichteten Materials erfolgt. Eine Unterteilung in mehrere Behandlungszonen bzw. -kammern mit verschiedenen Behandlungflüssigkeiten in muldenförmigen Tauchbädern ist nicht vorgesehen. Die GB-A- 1,276,383 beschreibt ein Entwicklungsgerät mit einem muldenförmigen Tank, der eine Anzahl von Wannen mit Behandlungsflüssigkeiten aufnimmt. Die Behandlung, in drei Zonen mit geradliniger Führung, geschieht durch einseitiges Besprühen des Materials mit den jeweiligen Behandlungsflüssigkeiten. Da das zu entwickelnde Material horizontal durch das Gerät hindurchgeführt wird, ist eine kompakte Bauweise nicht möglich, da jede Behandlungszone, die eine bestimmte Länge aufweisen muß, um die erforderliche Einwirkzeit der Behandlungsflüssigkeit auf das Material sicherzustellen, horizontal an die vorangehende Zone anschließt, so daß sich die Längen der Zonen summieren. Im Vergleich dazu wird bei einer bogenförmigen Führung des Materials die Horizontalausdehnung der einzelnen Zone, bei gleichbleibender Zonenlänge, verkürzt, so daß die gesamte Horizontalausdehnung des Geräts verringert wird.

Bekannte Entwicklungsgeräte mit muldenförmigen Tauchbädern in Zweikammernkombination sind im allgemeinen als Tischdurchlaufgeräte oder als Standgeräte zur vollautomatischen Entwicklung von Fotopapieren, Druckplatten oder dgl. einsetzbar. Dabei ergibt sich oft die Schwierigkeit, daß die zu entwickelnden Materialien nach dem Durchlauf unerwünscht gekrümmt sind und Kratzer auf der Ober- und/oder Unterseite aufweisen. Dabei ist auch die Ausentwicklung nicht zufriedenstellend. Bei kontinuierlichem längeren Gebrauch beginnen häufig auch die Behandlungsbäder zu schäumen, so daß die Entwicklung abgebrochen werden muß, um den Entwickler zu wechseln, Antischaummittel zuzufügen, oder es muß die Verarbeitungsgeschwindigkeit reduziert werden. Es kommt auch des öfteren vor, daß die verarbeiteten Materialien noch feucht, d.h. nicht genügend abgequetscht, das Gerät verlassen, so daß noch ein weiterer Trocknungsschritt erforderlich wird.

Zur Vermeidung dieser Nachteile wird im deutschen Gebrauchsmuster G 80 28 682 ein Entwicklungsgerät mit einer Zweiwannenkombination vorgeschlagen, in dem vor dem Auslaufbereich der Entwicklerwanne eine rotierende Bürstwalze mit federnd gelagerter Gegenwalze angeordnet ist, wobei die Bürstwalze durch eine Schutzhaube abgedeckt ist, deren, in Durchlaufrichtung gesehen, hintere Unterkante sich bis unter das Entwicklerflüssigkeitsniveau erstreckt. Für den Transport des Materials durch die beiden Wannen sind zusätzlich zu den Transportwalzenpaaren schichtseitig drehbare Umlenkrollen und rückseitig feststehende Führungsmittel vorgesehen. Das Gerät enthält im Übergangsbereich von Entwickler- und Nachbehandlungswanne Aus- und Einlaufwalzenpaare, die mit Hilfe von Umlenkrollen das behandelte Material so führen, daß es rückseitig den Trennsteg zwischen den beiden Wannen nicht flächig streift, wodurch die unerwünschte Kratzerbildung auf dem verarbeiteten Material vermieden wird.

Aus der US-A- 3,732,808 (DE-A- 22 38 414) ist eine Entwicklungsvorrichtung für Offsetdruckplatten bekannt, die Einrichtungen aufweist, mit denen gleichzeitig beide Seiten der Offsetdruckplatte oder eine Seite von zwei einzelnen Oberflächen von Offsetdruckplatten, die Rücken an Rücken aneinander liegen, entwickelt werden können. Das Entwicklungsgerät umfaßt Einrichtungen, die gleichzeitig Entwicklerlösung auf die einander gegenüberliegenden Oberflächen der Druckplatte aufbringen, ferner Bürsteinrichtungen, die gleichzeitig die beiden Oberflächen bürsten, um die chemische Reaktion der Entwicklerlösung zu unterstützen, sowie Bürstenwalzen zum Entfernen der Entwicklerlösung von den sich gegenüberliegenden Oberflächen der Druckplatte und Antriebseinrichtungen für den Transport der Druckplatte durch das Gerät. Das Gerät verwendet im Entwicklerteil kein Tauchbad, so daß die Druckplatte geradlinig durch das Gerät geführt werden kann. Es ist nur eine Entwicklung und Reinigung möglich, nicht jedoch eine Konservierung.

Aufgabe der Erfindung ist es, ein Verarbeitungsgerät der im Oberbegriff des Patentanspruchs 1 beschriebenen Art so zu verbessern, daß ein Kompaktgerät zum beidseitigen Entwickeln im Tauchbad, Wässern und Konservieren der zu verarbeitenden Materialien erhalten wird, in dem die Unter- und Oberseite der Materialien gleichzeitig bearbeitet werden, und das eine schonende und gleichmäßige Behandlung beider Seiten der Materialien ohne nachteilige Oberflächenveränderungen und -verformungen ermöglicht.

Diese Aufgabe wird durch ein Verarbeitungsgerät nach dem Oberbegriff des Anspruchs 1 erfindungsgemäß dadurch gelöst, daß eine dritte Behandlungszone mit einem herausnehmbaren Wanneneinsatz vorgesehen ist, daß ein Wannenunterteil integral ausgebildet ist und die Wanneneinsätze der drei Behandlungszonen aufnimmt, daß an die Ober- und Unterseite des zu entwickelnden Materials die Behandlungsflüssigkeiten in jeder der Behandlungszonen angetragen werden und daß das Material innerhalb jeder Behandlungszone im Antragsbereich für die jeweilige Behandlungsflüssigkeit geradlinig geführt ist.

Die weitere vorteilhafte Ausgestaltung der Erfindung ergibt sich aus den Merkmalen der übrigen Patentansprüche.

Mit der Erfindung wird der Vorteil erzielt, daß ein kompaktes preiswertes Dreikammergerät für Materialbreiten bis zu 700 mm alle Verarbeitungsschritte unter optimalen Bedingungen ermöglicht und darüber hinaus Korrekturen an den entwickelten Materialien vor der Konservierung schnell durchgeführt werden können, ohne daß diese bei einem neuerlichen Durchlauf durch das Gerät die Entwicklungszone passieren müssen.

Die Erfindung wird im folgenden anhand von zeichnerisch dargestellten Ausführungsbeispielen näher erläutert.

Es zeigen:

Fig. 1 eine perspektivische Ansicht eines Verarbeitungsgeräts nach der Erfindung,

Fig. 1A im Detail einen Auslauftisch des Verarbeitungsgerätes nach Fig. 1,

Fig. 2 eine schematische Schnittansicht durch eine Ausführungsform des Verarbeitungsgeräts nach Fig. 1,

Fig. 3 eine schematische Schnittansicht durch eine weitere Ausführungsform des Verarbeitungsgeräts nach Fig. 1,

Fig. 4 ein Detail aus einer der Behandlungszonen des Verarbeitungsgeräts,

Fig. 5 eine perspektivische Prinzipdarstellung einer der Behandlungszonen des Verarbeitungsgeräts,

Fig. 6 eine Schnittansicht durch eine Heizvorrichtung des Verarbeitungsgeräts,

Fig. 7a und 7b einen schematischen Verlauf der Wasserkühlung der Heizvorrichtung nach Fig. 6, und

Fig. 8 in schematischer Ansicht die Füllstandsanzeigen des Verarbeitungsgeräts.

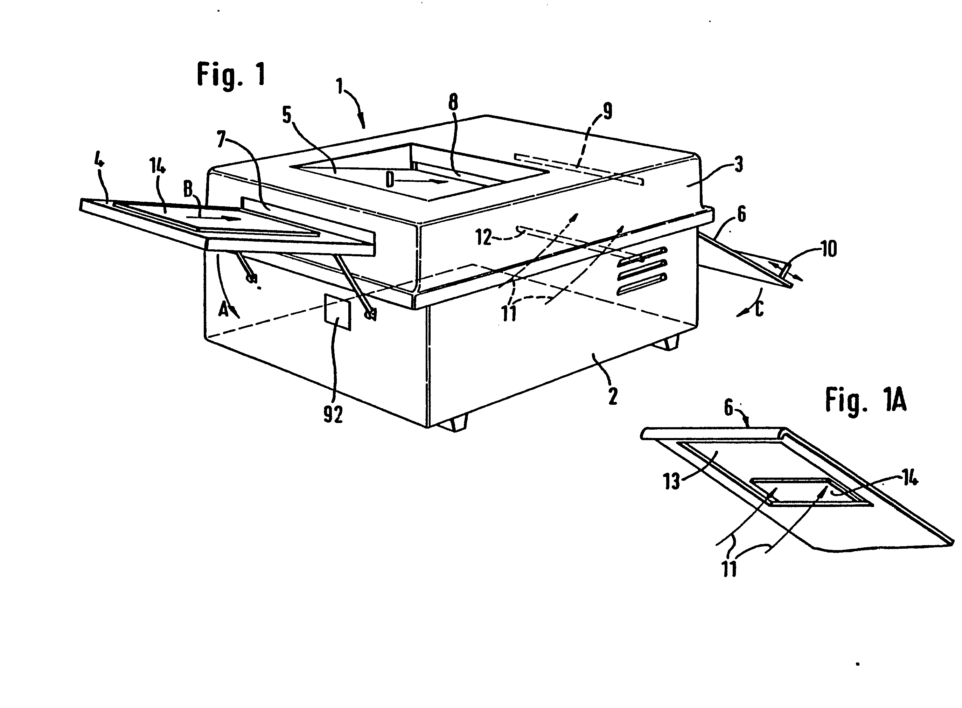

Das in Fig. 1 perspektivisch dargestellte Verarbeitungsgerät 1 besteht aus einem Gehäuseunterteil 2 und einem Gehäuseoberteil 3, der von dem Gehäuseunterteil 2 abhebbar ist. In der Frontplatte des Gehäuseunterteils 2 ist eine Füllstandsanzeigetafel 92 vorgesehen, von welcher der jeweilige Flüssigkeitsstand verschiedener Flüssigkeitsbäder im Inneren des Verarbeitungsgeräts 1 abgelesen werden kann. Im Gehäuseoberteil 3 sind zwei getrennte Eingabeschlitze 7 und 8 mit schräg nach unten geneigten Einlauftischen 4 und 5 angeordnet. Das zu verarbeitende Material 14, beispielsweise eine bildmäßig belichtete Druckplatte, wird in Richtung des Pfeils B in den Eingabeschlitz 7 bzw. in Richtung des Pfeils D in den Eingabeschlitz 8 eingeschoben. Der Einlauftisch 4 ist schwenkbar an der Vorderseite des Gehäuseoberteils 3 angebracht und wird im Stillstand des Verarbeitungsgeräts 1 in Richtung des Pfeils A angeklappt, um den Platzbedarf zu verringern. Der Einlauftisch 5 ist in die Oberseite des Gehäuseoberteils 3 integriert und verläuft ebenso wie der Einlauftisch 4 im ausgeklappten Zustand leicht schräg nach unten geneigt. Der Winkel dieser beiden Tische gegenüber der Horizontalen beträgt 5 bis 25°. Auf der Rückseite des Gehäuseoberteils 3 befindet sich ein Ausgabeschlitz 9 für das zu verarbeitende Material 14, durch den dieses auf einen Auslauftisch 6 rutscht, der an der Rückseite des Gehäuseoberteils 3 befestigt ist. Der Auslauftisch 6 ist schräg nach unten geneigt und mit einem verstellbaren anschlag 10 ausgerüstet. Während des Stillstandes des Verarbeitungsgeräts 1 kann der Auslauftisch 6 in Richtung des Pfeils C an die Rückseite des Verarbeitungsgeräts 1 angeklappt werden.

Im Gehäuseunterteil 2 ist ein Luftaustrittsschlitz 12 vorhanden, aus dem ein erwärmter Luftstrom 11, der in Fig. 1 durch gestrichelte Linien angedeutet ist, austritt und auf die Unterseite des Auslauftisches 6 auftrifft. Der Luftstrom wird durch ein Belüftungsgebläse erzeugt, wie dies noch nachstehend näher beschrieben werden wird.

In der Seitenwand des Gehäuseunterteils 2 sind Kiemenöffnungen bzw. Luftschlitze angeordnet, durch die Luft in das Innere des Verarbeitungsgeräts 1 strömt, die von der vom Belüftungsgebläse angesaugten Kaltluft mitgeführt wird. Diese Luftschlitze können an beliebiger Stelle der Seitenwand des Gehäuseunterteils 2 angeordnet sein und nicht nur in der in Fig. 1 gezeigten Position nahe der Rückseite des Verarbeitungsgeräts 1.

Fig. 1A zeigt eine Untersicht des Auslauftisches 6, der eine über seine Breite verlaufende Aussparung 13 aufweist, durch die der Luftstrom 11 hindurchströmt. Der verstellbare Anschlag 10 des Auslauftisches 6 wird für die Vorderkante des Materials 14 so positioniert, daß die Hinterkante des Materials 14 über der Aussparung 13 zu liegen kommt. Dadurch ist sichergestellt, daß der Luftstrom 11 sowohl einen Teil der Rückseite als auch der Hinterkante des Materials 14 überstreicht und somit die Behandlungsflüssigkeitsreste auf dem Material 14 abtrocknet. Dadurch wird eine zufriedenstellende Trocknung des Materials 14 erreicht, bevor es von dem Auslauftisch 6 abgenommen wird.

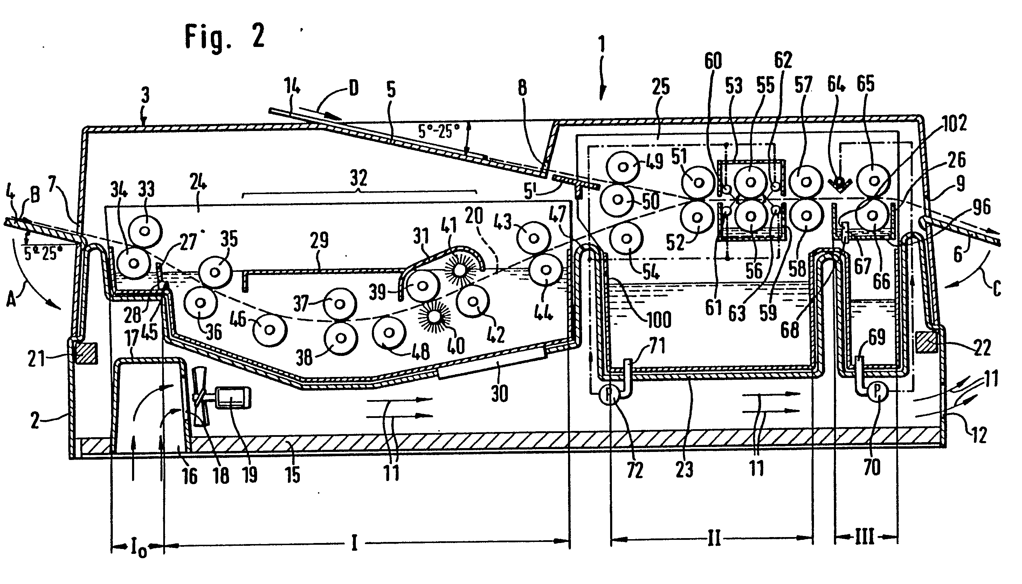

Die in Fig. 2 dargestellte Ausführungsform des Verarbeitungsgeräts umfaßt eine Vorbehandlungszone bzw. Vorkammer $I_0$ und drei Behandlungszonen I, II und III. Das zu verarbeitende blattförmige Material 14, z.B. eine bildmäßig belichtete Druckplatte, eine Druckplatte mit fixiertem Tonerbild, wobei der Träger der Druckplatte metallisch oder nichtmetallisch ist und aus Aluminium bzw. Papier oder Kunststoff besteht, wird über den schräg nach unten geneigten Einlauftisch 4 in Richtung des Pfeils B über den Eingabeschlitz 7 in das Innere des Verarbeitungsgerätes 1 geschoben. Die Transporteinrichtungen des Verarbeitungsgeräts 1 können entweder durch einen nicht gezeigten Fußschalter oder einen Näherungsschalter in der Fläche des Einlauftisches 4 eingeschaltet werden. Der Transport des zu verarbeitenden Materials 14 durch die einzelnen Zonen des Verarbeitungsgeräts 1 erfolgt längs einer gestrichelt dargestellten Materialbahn 20. Es können Materialien mit einer Bahnbreite bis zu 700 mm und einer Dicke bis zu 0,8 mm verarbeitet werden, jedoch ist auch eine Verarbeitung breiterer und dickerer Materialien möglich. Das zu verarbeitende Material 14 kann sowohl auf der Oberseite als auch auf der Unterseite gleichzeitig entwickelt, gewässert und konserviert werden. Aus diesem Grund ist auch der Einlauftisch 4 mit einem speziellen Belag für beidseitig zu verarbeitende Materialien versehen, wobei dieser Belag sicherstellt, daß die bildmäßig belichteten Stellen bzw. das entwickelte Bild auf der Unterseite der zu verarbeitenden Materialien nicht beschädigt wird.

Der Rahmen des Verarbeitungsgeräts 1 besteht aus einer Grundplatte 15 sowie Trägern 21 und 22, die den Gehäuseunterteil 2 tragen. Dieser Gehäuseunterteil 2 ist im Inneren des Verarbeitungsgeräts 1 als Wannenunterteil 23 ausgebildet, der beispielsweise als Tiefziehteil geformt ist und beispielsweise Wannen mit den Flüssigkeitsbädern bzw. Wanneneinsätze oder Rackeinsätze für die Materialbehandlung und den Materialtransport aufnimmt. In der Grundplatte 15 ist eine Öffnung 16 vorgesehen, durch die Luft in einen Luftführungskanal 17 einströmt. Der Luftführungskanal 17 besitzt in einer Seitenwand eine Öffnung 18, an die außerhalb des Lüftungskanals 17 ein Belüftungsgebläse 19 angrenzt. Die durch die Öffnung 16 in den Luftführungskanal 17 einströmende Luft wird durch das Belüftungsgebläse 19 erwärmt und als Luftstrom 11 unterhalb des Wannenunterteils 23 entlanggeführt und tritt aus dem Luftaustrittsschlitz 12 im Bereich des Auslauftisches 6 nach oben gerichtet aus. Durch die in Stufen verstellbare Leistung des Belüftungsgebläses 19 ist ein ausreichender Trocknungsgrad des zu verarbeitenden Materials 14 erreichbar, bevor dieses noch auf den Auslauftisch 6 gelangt.

Das in das Verarbeitungsgerät 1 eingeführte Material 14 gelangt zuerst in die Vorbehandlungszone bzw. Vorkammer $I_0$, in der ein Einlaufwalzenpaar 33, 34 angeordnet ist. Die Vorkammer $I_0$ ist von dem Entwicklerflüssigkeitsbad in der ersten Behandlungszone I durch einen Trennsteg 27 getrennt, der Öffnungen 28 enthält, die durch Stopfen 45 verschließbar sind. Werden diese Stopfen 45 entfernt, so stellt sich in der Vorkammer $I_0$ der gleiche Flüssigkeitspegel wie in der ersten Behandlungszone I ein, so daß die untere Einlaufwalze 34 in die Entwicklerflüssigkeit eintaucht und die obere Entwicklerwalze 33 befeuchtet, wodurch eine Vorentwicklung des Materials 14 durch die entwicklerfeuchten Einlaufwalzen 33 und 34 erfolgt. Ist eine derartige Vorentwicklung nicht erwünscht, so werden die Öffnungen 28 durch die Stopfen 45 verschlossen, so daß sich keine Entwicklerflüssigkeit in der Vorkammer $I_0$ befindet und das Einlaufwalzenpaar 33, 34 das Material 14 trocken weitertransportiert. Das Wannenunterteil 23 ist in der Behandlungszone I muldenförmig ausgebildet und nimmt eine Wanne 24 bzw. einen Wanneneinsatz auf, der u.a. den Trennsteg 27 und sämtliche Rackeinrichtungen der ersten Behandlungszone I und der Vorkammer $I_0$ enthält. Beim Weitertransport des Materials 14 entlang der Materialbahn 20 erfaßt ein Transportwalzenpaar 35, 36 im gekrümmten Teil der Materialbahn 20 die Vorderkante des Materials und leitet dieses bogenförmig weiter. Zum Abstützen des Materials 14 ist eine Stützwalze 46, der keine Gegenwalze gegenüberliegt vorgesehen. An der tiefsten Stelle der Materialbahn 20 in der Behandlungszone I befindet sich ein Umlenkwalzenpaar 37, 38, das das Material 14 aus dem gekrümmten Verlauf schräg nach oben umlenkt, so daß es die Bürstwalzen geradlinig durchläuft. Dem Umlenkwalzenpaar 37, 38 ist eine weitere Stützwalze 48 nachgeschaltet, an die eine Antragseinrichtung für die Entwicklerflüssigkeit an das Material 14 anschließt. Diese Antragseinrichtung besteht aus je einer unterhalb und oberhalb der ansteigenden Materialbahn 20 angeordneten Bürstwalze 40 bzw. 41 mit zugehöriger Gegenwalze 39 bzw. 42. Diese Bürstwalzen 40, 41 laufen mit vorgegebener, zur Materialtransportgeschwindigkeit unterschiedlicher Geschwindigkeit von beispielsweise 150 Umdrehungen pro Minute um. Die Bürstwalzen 40, 41 rotieren dabei in Transportrichtung des Materials 14. Die Gegenwalzen 39 und 42 zu den Bürstwalzen werden nur mit der Materialtransportgeschwindigkeit angetrieben und sind beispielsweise Gummiwalzen. Das Wannenunterteil 23 bzw. der Wanneneinsatz 24 ist unterhalb der Antragseinrichtung aus den Bürstwalzen und den Gegenwalzen geradlinig nach oben geneigt und enthält eine Heizeinrichtung 30, die für eine Flüssigkeitstemperierung im Bereich von 20 bis 30 °C sorgt.

Diese Heizeinrichtung 30, die noch näher beschrieben werden wird, besitzt eine große Wärmeaustauschfläche bei relativ geringer elektrischer Heizleistung. Dadurch wird erreicht, - besonders bei lösungsmittelhaltigen Entwicklern - daß die örtlichen Überhitzungen gering bleiben und daß eine Umwälzpumpe für das Flüssigkeitsbad, die während des Stillstandes des Gerätes normalerweise eingeschaltet wird, nicht erforderlich ist, da es wegen der geringen örtlichen Überhitzungen nicht zu Verklumpungen in der Entwicklerflüssigkeit kommt. Die Anordnung der Bürstwalzen mit den angetriebenen Gegenwalzen bei geradlinigem Materialdurchlauf ermöglicht ein definiertes Bürsten der Ober- und Unterseite des Materials. Dadurch, daß die muldenseitige Bürstwalze 40 zuerst angeordnet ist, werden die unterschiedlichen Benetzungsintensitäten der Ober-und Unterseite des Materials 14 bei einer Vorentwicklung durch entwicklerfeuchte Einlaufwalzen 33 und 34 kompensiert.

Eine Abdeckung 32, die zugleich auch einen Verdrängungskörper für die Entwicklerflüssigkeit bildet, ermöglicht es, mit weniger Entwicklerflüssigkeit im Flüssigkeitsbad eine einwandfreie Entwicklung zu erzielen und erstreckt sich von dem Transportwalzenpaar 35, 36 bis hinter die Bürstwalze 41 und besteht aus einem Horizontalteil 29 und einem die Bürstwalzen 40, 41 und deren Gegenwalzen 39, 42 umfassenden, nach oben geneigten Schrägteil 31. Die Abdeckung 32 taucht mit ihren Kanten in das Flüssigkeitsbad ein, wobei der Horizontalteil 29 im allgemeinen weiter aus dem Flüssigkeitsbad herausragt, d.h. höher als das Flüssigkeitsniveau liegt, als dies in Fig. 2 dargestellt ist, und verringert die freie Flüssigkeitsbadoberfläche erheblich, wodurch die Einsatzzeit für den Entwickler erhöht wird, da die Entwicklerflüssigkeit z.B. weniger Sauerstoff und/oder Kohlendioxid aus der Umgebungsluft aufnimmt. Da die Abdeckung 32 gleichzeitig auch ein Verdrängungskörper für die Entwicklerflüssigkeit ist, wird weniger Entwicklerflüssigkeit für das Tauchbad in dem Wanneneinsatz 24 benötigt. Als Entwicklerflüssigkeit kommen Lösungen in Frage, die anorganische und/oder organische alkalische Substanzen in Wasser und/oder organischen Lösungsmitteln enthalten, so daß neben der üblichen Entwicklung auch z.B. die Entschichtung von auf elektrofotografischem Weg hergestellten tonerbildfixierten Schichten möglich ist. Durch die Bürstwalzen 40 und 41 erfolgt eine gute Ausentwicklung der Oberflächen des Materials 14 und darüber hinaus bewirken die beispielsweise wendelförmig angebrachten Borsten der Bürstwalzen eine Badumwälzung. Nachdem das Material 14 die Bürstwalzeneinrichtung verlassen hat, wird es von den Transportwalzen 43, 44 im Auslauf der Behandlungszone I erfaßt und die auf den Oberflächen anhaftende Entwicklerflüssigkeit durch diese Walzen weitgehend abgequetscht. Ein Steg 47 trennt die Behandlungszone I von der Behandlungszone II und das Material 14 wird geradlinig und schräg nach oben, ohne Berührung, über diesen Trennsteg 47 in die Behandlungszone II transportiert. Die Behandlungszone II enthält eine Wanne bzw. einen Wanneneinsatz 25 mit zwei Mulden, von denen die eine Wasser als Behandlungsflüssigkeit und die zweite eine Konservierungsflüssigkeit, beispielsweise zum Gummieren des fertig entwickelten Materials 14 enthält.

Das in die Behandlungszone II eintretende Material 14 wird von Walzen 50, 54 zu einem Umlenkwalzenpaar 51, 52 geleitet. Von dem Umlenkwalzenpaar 51, 52 läuft das Material 14 horizontal in eine Flüssigkeitsauftragskammer 53 und wird durch diese mittig hindurchgeführt. In der Flüssigkeitsauftragskammer 53 sind zwei Paare von Sprührohren 60, 61 sowie 62, 63 vorhanden, die nahe dem Eintritt und dem Austritt der Materialbahn 20 angeordnet sind. Im horizontalen Bereich der Flüssigkeitsauftragskammer erfolgt erstmals beidseitig ein Wasserantrag über die Sprührohre 60, 61 bzw. 62, 63. Nach dem ersten Antrag von Wasser auf das Material 14 wird das Spülwasser durch ein Abquetschwalzenpaar 55, 56, das zwischen den zwei Paaren von Sprührohren angebracht ist, abgequetscht und anschließend durch das Sprührohrpaar 62, 63 zum zweiten Mal Spülwasser beidseitig angetragen. Durch den zweimaligen Wasserantrag und das dazwischen erfolgte Abquetschen wird ein optimaler Spüleffekt erreicht. Die unterhalb der Materialbahn 20 befindliche Abquetschwalze 56 taucht in das Flüssigkeitsbad der Flüssigkeitsauftragskammer 53 ein. Die Wanne der Auftragskammer besitzt einen Überlauf 59, der ein konstantes Flüssigkeitsniveau in der Auftragskammer 53 sicherstellt. Das aus der Flüssigkeitsauftragskammer 53 überlaufende Spülwasser wird von der unter dem Wasserbad angeordneten Mulde des Wanneneinsatzes 25 aufgefangen. Diese Mulde besitzt gleichfalls einen Überlauf 100, der ein gleichbleibendes Flüssigkeitsniveau innerhalb der Mulde sicherstellt, wenn es zu einer Spülwassererneuerung durch Spülwasser von der Heizeinrichtung 30 kommt.

In das Flüssigkeitsbad des Wanneneinsatzes 25 in der Behandlungszone II ragt ein Saugstutzen 71 einer Pumpe 72 mit Elektroantrieb hinein. Diese Pumpe 72 ist in Fig. 2 nur schematisch angedeutet, ebenso die Verbindung von dieser Pumpe 72 zu den Sprührohren 60, 61 bzw. 62, 63.

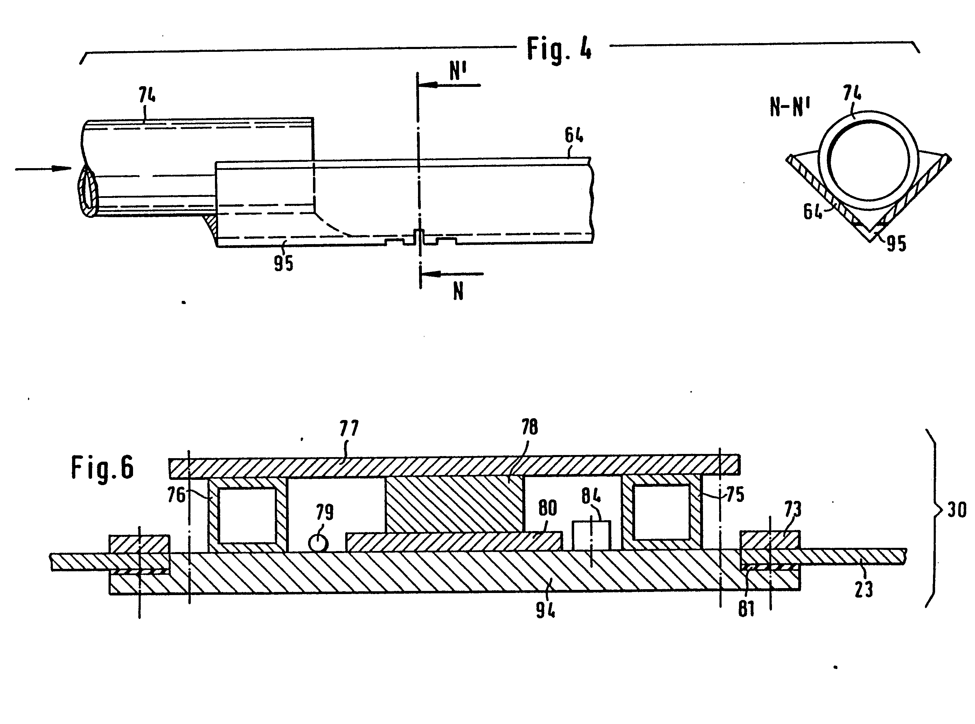

Nachdem das Material 14 die Flüssigkeitsauftragskammer 53 verlassen hat, wird es von einem weiteren Abquetschwalzenpaar 57, 58 erfaßt und in die dritte Behandlungszone III transportiert, in der oberhalb der Materialbahn 20 eine düsenlose Rinne 64 angeordnet ist, die einen V-förmigen Querschnitt mit Schlitzen 95 (vgl. Fig. 4, Schnitt N-N') aufweist. Über die Rinne 64 wird Behandlungsflüssigkeit auf das Material 14 angetragen. Diese Behandlungsflüssigkeit dient zum Konservieren, beispielsweise durch Gummieren des Materials 14. In der Behandlungszone III ist die Plattendurchlaufebene bzw. die Materialbahn 20 in Auslaufrichtung flach geneigt. Nach der Rinne 64 ist ein Auslaufwalzenpaar 65, 66 angeordnet, wobei die untere Auslaufwalze 66 in den mit Behandlungsflüssigkeit gefüllten Wanneneinsatz 26 eintaucht und als Auftragswalze für die Behandlungsflüssigkeit auf die Plattenunterseite dient. Die Wanne ist mit einem Grundablauf 67 versehen, den ein Stopfen 68 verschließt. Der Stopfen 68 weist einen Ablauf 102 für eine definierte Flüssigkeitshöhe innerhalb des Wanneneinsatzes 26 auf. Zum Reinigen und zum Ablassen der Behandlungsflüssigkeit wird der Stopfen 68 entfernt. Zusätzlich besitzt der Wanneneinsatz 26 an seiner tiefsten Stelle eine Öffnung 96, deren Querschnitt so bemessen ist, daß bei leerem Wanneneinsatz 26 und geringster Pumpenförderung die von der Rinne 64 abfließende Behandlungsflüssigkeit den Wanneneinsatz in der Zeit, bis eine in das Verarbeitungsgerät 1 eingeführte Druckplatte das Auslaufwalzenpaar 65, 66 erreicht, füllt. Die von der Rinne 64 abtropfende und überlaufende Behandlungsflüssigkeit wird in dem Wanneneinsatz 26 aufgefangen, der nach oben offen ist und aus dem Bereich der dritten Behandlungszone III herausnehmbar ist.

In den Behandlungszonen I bis III sind jeweils die Walzen, Seitenteile, Pumpen und Sprührohre nach Lösen einer nicht gezeigten antriebskupplung nach oben entnehmbar, um die Wanneneinsätze bzw. Mulden für Reinigungszwecke zugänglich zu machen.

Das Material 14 verläßt beidseitig konserviert und durch das Auslaufwalzenpaar 65, 66 abgequetscht das Verarbeitungsgerät 1 und gelangt auf den Auslauftisch 6. Wie schon zuvor erwähnt wurde, wird von dem Belüftungsgebläse 19 Warmluft von unten gegen die Materialrückseite geblasen. Es kann noch zusätzlich ein Warmluftgebläse mit einer in Stufen verstellbaren Heizleistung vorgesehen werden, um einen ausreichenden Trocknungsgrad des Materials 14 zu erzielen, bevor dieses noch auf den Auslauftisch 6 rutscht.

Der Nachlauf eines solchen Warmluftsgebläses und weitere Einheiten des Verarbeitungsgerätes 1 wird in üblicher Weise durch ein Zeitrelais geregelt. Für eine minimale Einschaltzeit des Verarbeitungsgerätes 1 kann ein Sollwertgeben für die Durchlaufgeschwindigkeit des Materials 14 mit einem Sollwertgeben des Zeitrelais mechanisch gekuppelt werden. Vom Start des Verarbeitungsgerätes durch eine Fuß- oder Näherungsschalter wird so, je nach gewählter Transportgeschwindigkeit des Materials 14, die richtige Nachlaufzeit automatisch mitgeregelt bzw. miteingestellt.

Bei der Verarbeitung von Druckplatten, beispielweise inbesondere von Positiv-Druckplatten ist nach der Vornahme notwendiger Korrekturen an der entwickelten Platte ein separates Konservieren nötig. Hierzu weist das Verarbeitungsgerät 1 den Einlauftisch 5 auf, der in den Eingabeschlitz 8 mündet. Hier eingeschobene Druckplatten werden ohne bleibende Verformung nahezu geradlinig in Richtung der Behandlungszone II transportiert. Hierzu ist in Verlängerung des Einlauftisches 5 ein T-ähnliches Teil 5' vorgesehen, das sicherstellt, daß die relativ dünne Druckplatte nach dem Durchgang durch den Eingabeschlitz 8 geradlinig weitertransportiert wird. Die Druckplatte wird von dem Walzenpaar 49, 50 erfaßt und über das Umlenkwalzenpaar 51, 52 der Flüssigkeitsauftragskammer 53 zugeführt.

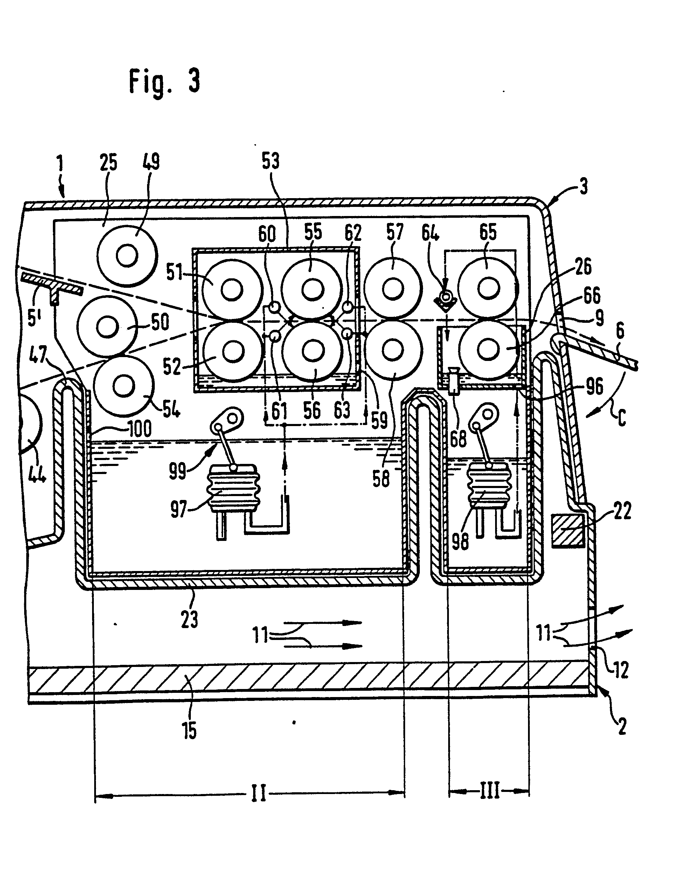

Eine weitere Ausführungsform des Verarbeitungsgeräts 1 nach der Erfindung ist in Fig. 3 gezeigt, wobei aus Gründen der besseren Übersichtlichkeit die mit der Ausführungsform nach Fig. 2 identische erste Behandlungszone I weggelassen ist. Übereinstimmende Bauteile beider Ausführungsformen sind mit den gleichen Bezugszahlen belegt.

Die bevorzugte Ausführungsform nach Fig. 3 unterscheidet sich von der Ausführungsform nach Fig. 2 dadurch, daß anstelle von Pumpen mit Elektroantrieb, die außerhalb und unterhalb des Wannenunterteils 23 angeordnet sind, Faltenbalgpumpen vorgesehen sind, die sich innerhalb der Flüssigkeitsbäder der zweiten und der dritten Behandlungszone II bzw. III befinden. So sind beispielsweise in der zweiten Behandlungszone II mehrere Faltenbalgpumpen 97 vorgesehen, von denen nur eine einzige in Fig. 3 dargestellt ist. In der dritten Behandlungszone III ist eine einzige Faltenbalgpumpe 98 vorhanden. Jede der Faltenbalgpumpen 97 bzw. 98 ist über ein Gestänge und einen Exzenter 99 mit einem Antrieb für die verschiedenen Abquetsch-, Umlenk- und Transportwalzen verbunden. Somit erfolgt der Antrieb der Faltenbalgpumpen 97, 98 für den Antrag der Behandlungsflüssigkeiten synchron zu dem Walzenantrieb, da er von diesem abgeleitet ist. Wie in Fig. 3 durch strich-punktierte Linien, die von den Austrittsleitungen der Faltenbalgpumpen 97 bzw. 98 ausgehen, angedeutet ist, sind diese Austrittsleitungen mit den Sprührohren 60, 61 sowie 62, 63 bzw. mit der Rinne 64 verbunden, um diese mit der jeweiligen Behandlungsflüssigkeit zu beschicken. Ein wesentlicher Vorteil der Faltenbalgpumpen besteht darin, daß beim Entnehmen des Transporteinsatzes aus der Behandlungszone weder elektrische Stecker im Naßbereich noch Schlauchkupplungen aufgetrennt werden müssen und daß durch den Antrieb der Faltenbalgpumpen, der vom Walzentransportantrieb abgeleitet ist, ein der Materialdurchlaufgeschwindigkeit proportionaler Flüssigkeitsantrag erfolgt. Nach Fig. 3 ist das Umlenkwalzenpaar 51, 52 innerhalb der Flüssigkeitsauftragskammer 53 angeordnet, wobei die untere Umlenkwalze 52 in das Flüssigkeitsbad eintaucht. Eine derartige Anordnung ist vor allem dann zweckmäßig, wenn der Entwickler auf dem zu entwickelnden Material 14, insbesondere auf Druckplatten, stark haftet. Dann wird nämlich durch das Umlenkwalzenpaar 51, 52 schon eine Vorreinigung der Druckplatte vorgenommen, bevor noch Spülwasser durch die Sprührohre 60 bis 63 an die Druckplatte angetragen wird. Selbstverständlich ist es auch möglich, daß die Umlenkwalzen 51, 52 ebenso wie bei der Ausführungsform nach Fig. 2 außerhalb der Flüssigkeitsauftragskammer 53 angeordnet sind.

Fig. 4 zeigt die Rinne 64 der dritten Behandlungszone III sowie eine Schnittansicht längs der Linie N-N' der Rinnenanordnung. In die V-förmige Rinne 64 ragt von beiden Enden her je ein Zulaufrohr 74 in die Rinne hinein, wobei in Fig. 4 nur eines dieser Zulaufrohre 74 dargestellt ist. Es ist selbstverständlich, daß auch nur ein einziges derartiges Zulaufrohr 74 vorgesehen werden kann. Die Zulaufrohre 74 sind, wie zuvor schon erwähnt wurde, mit der Auslaßleitung der Pumpe 70 bzw. der Faltenbalgpumpe 98 (nicht dargestellt) verbunden.

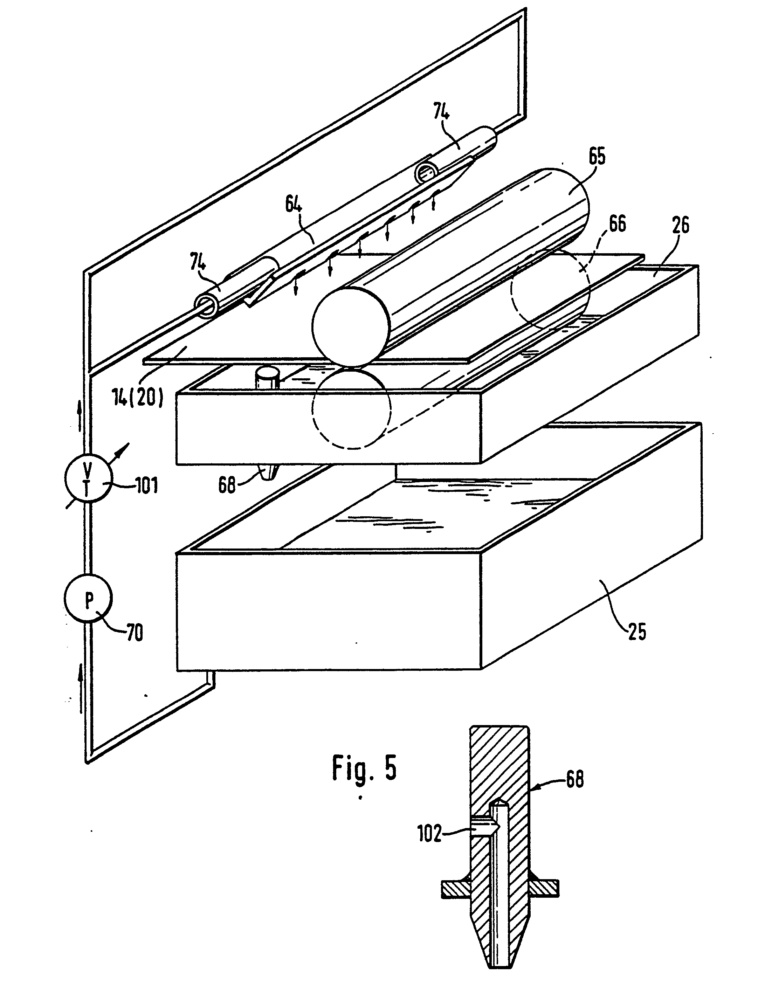

In Fig. 5 ist schematisch und perspektivisch die dritte Behandlungszone III des Verarbeitungsgeräts 1 nach der Ausführungsform gemäß Fig. 2 gezeigt. Ein Teil der Materialbahn 14 bzw. der Plattendurchlaufebene 20 zwischen den Rollen 65, 66 ist dargestellt. Von beiden Seiten ragen in die Rinne 64 die Zulaufrohre 74 hinein, bei denen es sich beispielsweise um Schlauchstutzen mit eingelöteten Rohrstücken handeln kann. Das Material wird entlang der Materialbahn 20 bewegt und durchläuft den Spalt zwischen den Auslaufwalzen 65 und 66, die Behandlungsflüssigkeit von dem Entwicklungsmaterial abquetschen. Dabei taucht die untere Auslaufwalze 66 in die Behandlungsflüssigkeit ein. Der Stopfen 68 kann der Wanne 26 entnommen werden, um die Behandlungsflüssigkeit in die darunter befindliche Wanne 25 abfließen zu lassen, so daß die leere Wanne 26 gereinigt oder ein Wechsel der Behandlungsflüssigkeit vorgenommen werden kann. Der Stopfen 68 weist den seitlichen Ablauf 102 auf, durch den das Flüssigkeitsniveau in der Wanne 26 konstant gehalten wird. Vom Boden der Wanne 25 führt eine Leitung zu der Pumpe 70, deren Ausgangsseiten über eine Drossel 101 zur Begrenzung des Flüssigkeitsstromes mit den Zulaufrohren 74 verbunden ist. Der Schnitt durch den vergrößert dargestellten Stopfen 68 in Fig. 5 verdeutlicht die seitliche Lage des Ablaufes 102.

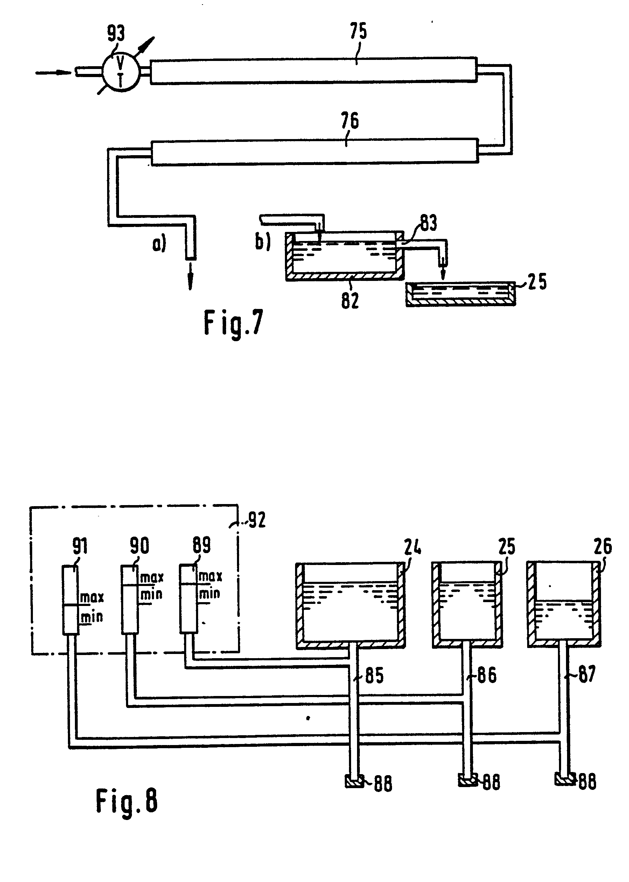

Einzelheiten der Heizeinrichtung 30 sind aus Fig. 6 ersichtlich. Eine Wärmeaustauschplatte 94 der Heizeinrichtung 30 ist in eine Öffnung des Wannenunterteils 23 eingefügt. Die mechanische Verbindung zwischen der Wärmeaustauschplatte 94 und dem Wannenunterteil 23 erfolgt in der Weise, daß Dichtungen 81 zwischen einem Bund der Wärmeaustauschplatte 94 und der Unterseite des Wannenunterteils 23 vorgesehen sind und daß darüber auf der Oberseite des Wannenunterteils 23 Gewindeleisten 73 vorhanden sind, über die eine Schraubverbindung zwischen dem Wannenunterteil 23 und der Wärmeaustauschplatte 94 hergestellt wird. Auf der Wärmeaustauschplatte 94 sitzt mittig eine elektrische Heizplatte 80 auf, die einen Zwischenblock 78 trägt, auf dem eine Anpaßplatte 77 aufliegt. Unterhalb und nahe dem Rande der Anpaßplatte 77 verlaufen die Kühlkanäle 75, 76, die, wie schon erwähnt wurde, mit dem Flüssigkeitsbad in der zweiten Behandlungszone II in Verbindung stehen können. Ein Thermostat 79 regelt die Heizleistung der Heizeinrichtung 30 entsprechend dem eingestellten Temperaturwert. Zur Vermeidung einer Überhitzung der Heizplatte 80 ist ein Überhitzungsschutz 84 vorgesehen.

Wie aus Fig. 7 ersichtlich ist, befindet sich vor dem Kühlkanal 75 eine Drossel 93 zur Regelung der Kühlwassermenge. Das Kühlwasser fließt entweder direkt in den Abfluß, wie es in Fig. 7 durch die Position a) angedeutet ist, oder in einen Spülwassertank 82, der einen Überlauf 83 zum Konstanthalten des Flüssigkeitsniveaus besitzt, und von diesem Spülwassertank 82 in die Wanne 25 in der zweiten Behandlungszone II, wie aus der Position b) ersichtlich ist.

Die Füllstandsanzeige in den einzelnen Wannen 24, 25, 26 erfolgt über Füllstandsanzeigen 89, 90, 91, die nach dem Prinzip kommunizierender Röhren mit den Ablaßschläuchen 85, 86, 87 der Wannen 24, 25, 26 verbunden sind. Die Füllstandsanzeigen 89, 90, 91 sind in der Füllstandsanzeigetafel 92 integriert, die an der Frontplatte des Verarbeitungsgeräts 1 angeordnet ist. Jede der Füllstandsanzeigen ist mit einer Markierung für maximalen und minimalen Füllstand ausgerüstet. Für den Wechsel der Flüssigkeitsbäder in den Wannen 24, 25, 26 werden Stopfen 88 in den Ablaßschläuchen 85, 86, 87 entfernt.

**Patentansprüche**

1. Verarbeitungsgerät für bildmäßig belichtete fotoempfindliche Materialien, insbesondere Druckplatten, mit zumindest zwei Behandlungszonen, in denen herausnehmbare Wanneneinsätze vorhanden sind, die Transport- und Führungseinrichtungen zum kontinuierlichen bogen- und geradlinigen Führen des Materials durch die Behandlungszonen enthalten sowie in der ersten Behandlungszone Antragseinrichtungen mit einer Abdeckung, die zum Teil in die Behandlungsflüssigkeit hineinragt, dadurch gekennzeichnet, daß eine dritte Behandlungszone (III) mit einem herausnehmbaren Wanneneinsatz (26) vorgesehen ist, daß ein Wannenunterteil (23) integral ausgebildet ist und die Wanneneinsätze (24, 25, 26) der drei Behandlungszonen (I, II, III) aufnimmt, daß an die Ober- und Unterseite des zu entwickelnden Materials (14) die Behandlungsflüssigkeiten in jeder der Behandlungszonen (I, II, III) angetragen werden und daß das Material innerhalb jeder Behandlungszone im Antragsbereich für die jeweilige Behandlungsflüssigkeit geradlinig geführt ist.

2. Verarbeitungsgerät nach Anspruch 1, dadurch gekennzeichnet, daß zwei getrennte Eingabeschlitze (7, 8) für das Material (14) in einem Gehäuseoberteil (3) des Verarbeitungsgeräts (1) mit schräg nach unten geneigten Einlauftischen (4, 5) vorhanden sind, von denen der erste Einlauftisch (4) das zu bearbeitende Material einer Vorkammer ($I_o$) zuführt, die der ersten Behandlungszone (I) vorgeschaltet ist und der zweite Einlauftisch (5) das Material zu einem Umlenkwalzenpaar (51, 52) transportiert, das einer Flüssigkeitsantragskammer (53) in der zweiten Behandlungszone (II) vorgeschaltet ist.

3. Verarbeitungsgerät nach Anspruch 2, dadurch gekennzeichnet, daß die Neigung des ersten und zweiten Einlauftisches (4, 5) zur Horizontalen 5 - 25° beträgt, daß der erste Einlauftisch (4) abklappbar an dem Gehäuseoberteil (3) angelenkt ist und daß der zweite Einlauftisch (5) in dem Gehäuseoberteil (3) integriert ist.

4. Verarbeitungsgerät nach Anspruch 2, dadurch gekennzeichnet, daß in der Vorkammer ($I_o$) ein Einlaufwalzenpaar (33, 34) angeordnet ist und daß sich in einem Trennsteg (27) zwischen der Vorkammer ($I_o$) und dem Flüssigkeitsbad der ersten Behandlungszone (I) verschließbare Öffnungen (28) befinden.

5. Verarbeitungsgerät nach Anspruch 1, dadurch gekennzeichnet, daß die Materialbahn (20) bis zum tiefsten Punkt des Flüssigkeitsbades in der ersten Behandlungszone (I) gekrümmt verläuft und daß ab dem tiefsten Punkt die Materialbahn (20) bis zum Ende der ersten Behandlungszone geradlinig, schräg nach oben gerichtet ist.

6. Verarbeitungsgerät nach Anspruch 5, dadurch gekennzeichnet, daß unterhalb und oberhalb der ansteigenden Materialbahn (20) je eine Bürstwalze (40; 41) mit zugehöriger Gegenwalze (39; 42) angeordnet ist, daß die Bürstwalzen (40, 41) mit vorgegebener, zur Materialtransportgeschwindigkeit unterschiedlicher Geschwindigkeit umlaufen und daß eine Abdeckung (32) das Flüssigkeitsbad zwischen einem ersten Transportwalzenpaar (35, 36) und der in Transportrichtung hinteren Bürstwalze (41), unter Einschluß dieser Bürstwalze (41) so abdeckt, daß ein Luftschöpfen der Bürstwalze vermieden wird.

7. Verarbeitungsgerät nach Anspruch 6, dadurch gekennzeichnet, daß die Abdeckung (32) aus einem Horizontalteil (29) und einem die Bürstwalzen (40, 41) und deren Gegenwalzen (39, 42) umfassenden, nach oben geneigten Schrägteil (31) besteht.

8. Verarbeitungsgerät nach Anspruch 5, dadurch gekennzeichnet, daß der Wannenunterteil (23) der ersten Behandlungszone (I) unterhalb der Bürstwalzen (40, 41) im Wannenboden eine Heizeinrichtung (30) aufweist, die Kühlkanäle (75, 76) für eine Wasserkühlung enthält.

9. Verarbeitungsgerät nach Anspruch 8, dadurch gekennzeichnet, daß die Kühlkanäle (75, 76) mit dem Flüssigkeitsbad in dem Wanneneinsatz (25) der zweiten Behandlungszone (II) in Verbindung stehen.

10. Verarbeitungsgerät nach den Ansprüchen 1 bis 9, dadurch gekennzeichnet, daß in der zweiten Behandlungszone (II) die Flüssigkeitsauftragskammer (53) für die Behandlungsflüssigkeit vorhanden ist, durch welche die Materialbahn (20) mittig und horizontal hindurchführt, daß in der Flüssigkeitsauftragskammer (53) zwei Paare von Sprührohren (60, 61; 62, 63) vorhanden sind, die nahe dem Eintritt und dem Austritt der Materialbahn (20) in die Flüssigkeitsauftragskammer (53) angeordnet sind und daß zwischen den zwei Paaren von Sprührohren (60, 61; 62, 63) ein Abquetschwalzenpaar (55, 56) angebracht ist.

11. Verarbeitungsgerät nach Anspruch 10, dadurch gekennzeichnet, daß je eines der Sprührohre (60, 62 bzw. 61, 63) der beiden Paare oberhalb bzw. unterhalb der Materialbahn (20) angeordnet ist und daß die unterhalb der Materialbahn (20) befindliche Abquetschwalze (56) in das Flüssigkeitsbad eintaucht.

12. Verarbeitungsgerät nach Anspruch 10, dadurch gekennzeichnet, daß in das Flüssigkeitsbad des Wanneneinsatzes (25) der zweiten Behandlungszone (II) ein Saugstutzen (71) einer Pumpe (72) mit Elektroantrieb hineinragt, die mit den Sprührohren (60, 61, 62, 63) in Verbindung steht.

13. Verarbeitungsgerät nach Anspruch 1, dadurch gekennzeichnet, daß in der dritten Behandlungszone (III) oberhalb der Materialbahn (20) für den Antrag von Behandlungsflüssigkeit eine düsenlose Rinne (64) angeordnet ist, die einen V-förmigen Querschnitt mit Schlitzen (95) im Bereich der durchlaufenden Materialbahn entlang der Stoßkante aufweist und in die Zulaufrohre (74) münden.

14. Verarbeitungsgerät nach Anspruch 13, dadurch gekennzeichnet, daß in der dritten Behandlungszone (III) nach der Rinne (64) unterhalb und oberhalb der Materialbahn (20) Abquetschwalzen (65, 66) angeordnet sind, von denen die untere Abquetschwalze (66) in das Flüssigkeitsbad des Wanneneinsatzes (26) eintaucht und während des Betriebs Behandlungsflüssigkeit auf die Materialunterseite aufträgt, und daß der Wanneneinsatz (26) die von den Materialseiten und durch den Schlitz (95) ablaufende überschüssige Behandlungsflüssigkeit auffängt.

15. Verarbeitungsgerät nach Anspruch 14, dadurch gekennzeichnet, daß in das Flüssigkeitsbad der dritten Behandlungszone (III) ein Saugstutzen (69) einer Pumpe (70) mit Elektroantrieb hineinragt, die mit dem Zulaufrohr (74) zum Beschicken der Rinne (64) mit Behandlungsflüssigkeit in Verbindung steht und daß die Pumpe (70) unterhalb des Wannenunterteils (23) angeordnet ist.

16. Verarbeitungsgerät nach Anspruch 15, dadurch gekennzeichnet, daß die Wanne (26) einen Grundablauf (67) in die Flüssigkeitsvorratswanne der dritten Behandlungszone (III) aufweist und daß ein Stopfen (68) mit Ablauf (102) den Grundablauf (67) verschließt.

17. Verarbeitungsgerät nach Anspruch 14, dadurch gekennzeichnet, daß im Flüssigkeitsbad der zweiten und der dritten Behandlungszone (II, III) mehrere Pumpen (97, 97,...) bzw. eine einzige Pumpe (98) angeordnet sind, daß jede Pumpe (97) über Gestänge und einen Exzenter (99) mit einem Antrieb für die Walzen der verschiedenen Walzenpaare verbunden ist und daß die Druckseiten der Pumpen (97; 98) in der zweiten und der dritten Behandlungszone (II bzw. III) mit den Sprührohren (60, 61, 62, 63) bzw. mit den Zulaufrohren (74) für die Rinne (64) verbunden sind.

18. Verarbeitungsgerät nach Anspruch 15, dadurch gekennzeichnet, daß der Wanneneinsatz (26) eine Öffnung (96) aufweist, deren Querschnitt so bemessen ist, daß die durch die Öffnung (96) abfließende Menge an Behandlungsflüssigkeit kleiner als die über der Rinne (64) zufließende Menge an Behandlungsflüssigkeit ist.

19. Verarbeitungsgerät nach Anspruch 17, dadurch gekennzeichnet, daß alle Walzen mit Ausnahme der Bürstwalzen, mit einer Umfangsgeschwindigkeit gleich der Durchlaufgeschwindigkeit des zu verarbeitenden Materials (14) umlaufen und daß der Antrieb der Pumpen (97, 98) für den Antrag der Behandlungsflüssigkeiten synchron zu dem Walzenantrieb erfolgt und von diesem abgeleitet ist.

20. Verarbeitungsgerät nach den Ansprüchen 1 bis 19, dadurch gekennzeichnet, daß im Geräteunterteil (2) ein Belüftungsgebläse (19) angeordnet ist, dessen Luftstrom (11) unterhalb des Wannenunterteils (23) entlang geführt ist und aus dem Verarbeitungsgerät (1) aus einem Luftaustrittsschlitz (12) im Bereich eines Auslauftisches (6) für das zu verarbeitende Material (14) nach oben gerichtet austritt.

21. Verarbeitungsgerät nach Anspruch 20, dadurch gekennzeichnet, daß der Auslauftisch (6) eine über seine Breite verlaufende Aussparung (13) aufweist, durch die der Luftstrom des Belüftungsgebläses (19) gegen die Materialunterseite strömt.

22. Verarbeitungsgerät nach Anspruch 21, dadurch gekennzeichnet, daß der Auslauftisch (6) für die Vorderkante des Materials einen verstellbaren Anschlag (10) aufweist, der so positioniert ist, daß die Hinterkante des Materials (14) über der Aussparung (13) zu liegen kommt.

23. Verarbeitungsgerät nach Anspruch 10, dadurch gekennzeichnet, daß die untere Umlenkwalze (52) des in der Flüssigkeitsauftragskammer (53) angeordneten Umlenkwalzenpaars (51, 52) in das Flüssigkeitsbad der Flüssigkeitsauftragskammer (53) eintaucht.

**Claims**

1. A processing unit for photosensitive materials exposed imagewise especially printing plates, with at least two treatment zones in which there are removable tank inserts which contain transport and guide devices for the continuous arcuate and straight guidance of the material through the treatment zones, and in the first treatment zone application devices with a cover which projects partially into the treatment fluid, characterized in that there is a third treatment zone (III) with a removable tank insert (26), that a tank bottom part (23) is made integral and receives the tank inserts (24, 25, 26) of the three treatment zones (I, II, III), that in each of the treatment zones (I, II, III) the treatment fluids are applied to the top and bottom sides of the material (14) to be developed, and that the material is guided in a straight line, within each treatment zone, in the application region for the particular treatment fluid.

2. The processing unit as claimed in claim 1, characterized in that there are two separate feed slits (7, 8) for the material (14) in a housing top part (3) of the processing unit (1), with run-in tables (4, 5) inclined obliquely downwards, the first run-in table (4) of which feeds the material to be processed to a prechamber ($I_0$) located in front of the first treatment zone (I), and the second run-in table (5) transports the material to a pair of deflecting rollers (51, 52) which is located in front of a fluid-coating chamber (53) in the second treatment zone (II).

3. The processing unit as claimed in claim 2, characterized in that the inclination of the first and second run-in tables (4, 5) relative to the horizontal is 5 to 25°, that the first run-in table (4) is articulated so that it can be swung down against the housing top part (3), and that the second run-in table (5) is integrated in the housing top part (3).

4. The processing unit as claimed in claim 2, characterized in that a pair of run-in rollers (33, 34) is located in the prechamber ($I_0$), and that closable orifices (28) are located in a separating web (27) between the prechamber ($I_0$) and the fluid bath of the first treatment zone (I).

5. The processing unit as claimed in claim 1, characterized in that the material path (20) runs in a curve to the lowest point of the fluid bath in the first treatment zone (I), and that the material path (20) is directed obliquely upwards in a straight line from the lowest point.

6. The processing unit as claimed in claim 5, characterized in that a brushing roller (40; 41) with an associated counter-roller (39; 42) is located respectively underneath and above the ascending material path (20), that the brushing rollers (40, 41) revolve at a predetermined speed different from the material transport speed, and that a cover (32) covers the fluid bath between a first pair of transport rollers (35, 36) and the brushing roller (41) at the rear, seen in the transport direction, this brushing roller (41) being included in such a way that air entrainment by the brushing roller is prevented.

7. The processing unit as claimed in claim 6, characterized in that the cover (32) consists of a horizontal part (29) and of an upward-inclined sloping part (31) surrounding the brushing rollers (40, 41) and their counter-rollers (39, 42).

8. The processing unit as claimed in claim 5, characterized in that the tank bottom part (23) of the first treatment zone (I) has underneath the brushing rollers (40, 41) in the tank bottom a heating device (30) which contains cooling channels (75, 76) for water-cooling.

9. The processing unit as claimed in claim 8, characterized in that the cooling channels (75, 76) are connected to the fluid bath in the tank insert (25) of the second treatment zone (II).

10. The processing unit as claimed in claims 1 to 9, characterized in that there is in the second treatment zone (II) the fluid-coating chamber (53) for the treatment fluid, through which the material path (20) leads centrally and horizontally, that there are in the fluidcoating chamber (53) two pairs of spray tubes (60, 61; 62, 63) which are located near to the entrance and exit of the material path (20) in the fluid-coating chamber (53), and that a pair of squeezing-off rollers (55, 56) is attached between the two pairs of spray tubes (60, 61; 62, 63).

11. The processing unit as claimed in claim 10, characterized in that one of the spray tubes (60, 62 or 61, 63) of each of the two pairs is located above and below the material path (20) respectively, and that the squeezing-off roller (56), located below the material path (20), dips into the fluid bath.

12. The processing unit as claimed in claim 10, characterized in that there projects into the fluid bath of the tank insert (25) of the second treatment zone (II) a suction pipe (71) of a pump (72) with an electric drive, which is connected to the spray tubes (60, 61, 62, 63).

13. The processing unit as claimed in claim 1, characterized in that located in the third treatment zone (III), above the material path (20), for the application of treatment fluid is a nozzle-less channel (64) which has a V-shaped cross-section with slits (95) along the joining edge in the region of the material path running through and into which inflow tubes (74) open.

14. The processing unit as claimed in claim 13, characterized in that located in the third treatment zone (III), after the channel (64), below and above the material path (20) are squeezing-off rollers (65, 66), the lower squeezing-off roller (66) of which dips into the fluid bath of the tank insert (26) and coats treatment fluid onto the underside of the material during operation, and that the tank insert (26) collects the excess treatment fluid flowing off from the sides of the material and through the slit (95).

15. The processing unit as claimed in claim 14, characterized in that there projects into the fluid bath of the third treatment zone (III) a suction pipe (69) of a pump (70) with an electric drive, which is connected to the inflow tube (74) for feeding treatment fluid to the channel (64), and that the pump (70) is located underneath the tank bottom part (23).

16. The processing unit as claimed in claim 15, characterized in that the tank (26) has a base flow-off (67) into the fluid supply tank of the third treatment zone (III), and that a plug (68) with a flow-off (102) closes the base flow-off (67).

17. The processing unit as claimed in claim 14, characterized in that several pumps (97, 97, etc.) or a single pump (98) are located in the liquid baths of the second and third treatment zones (II, III) respectively, that each pump (97) is connected via a linkage and a cam (99) to a drive for the rollers of the various pairs of rollers, and that the pressure sides of the pumps (97; 98) in the sesond and third treatment zones (II and III respectively) are connected to the spray tubes (60, 61, 62, 63) or to the inflow tubes (74) to the channel (64) respectively.

18. The processing unit as claimed in claim 15, characterized in that the tank insert (26) has an orifice (96), the cross-section of which is such that the quantity of treatment fluid flowing off through the orifice (96) is less than the quantity of treatment fluid flowing in via the channel (64).

19. The processing unit as claimed in claim 17, characterized in that all the rollers, with the exception of the brushing rollers, revolve at a peripheral speed equal to the feed speed of the material (14) to be processed, and that the drive of the pumps (97, 98) for applying the treatment fluids is synchronous with the roller drive and is derived from this.

20. The processing unit as claimed in claims 1 to 19, characterized in that located in the unit bottom part (2) is a ventilation fan (19), the air stream (11) of which is guided along underneath the tank bottom part (23) and flows, directed upwards, out of the processing unit (1) from an air outflow slit (12) in the region of a run-out table (6) for the material (14) to be processed.

21. The processing unit as claimed in claim 20, characterized in that the run-out table (6) has a recess (13) which extends over its entire width and through which the air stream from the ventilation fan (19) flows against the underside of the material.

22. The processing unit as claimed in claim 21, characterized in that the run-out table (6) has for the front edge of the material an adjustable stop (10) which is positioned in such a way that the rear edge of the material (14) comes to rest over the recess (13).

23. The processing unit as claimed in claim 10, characterized in that the lower deflecting roller (52) of the pair of deflecting rollers (51, 52) located in the fluid-coating chamber (53) dips into the fluid bath of the fluid-coating chamber (53).

**Revendications**

1. Machine de traitement de matériaux photosensibles exposés sur lesquels est formée une image, en particulier de plaques d'impression, comportant au moins deux zones de traitement dans lesquelles se trouvent des bacs amovibles qui contiennent des dispositifs de transport et de guidage pour le guidage continu en courbe et en ligne droite du matériau à travers les zones de traitement, ainsi que, dans la première zone de traitement, des dispositifs d'application avec un couvercle qui pénètre en partie dans le liquide de traitement, caractérisée en ce qu'elle comporte une troisième zone de traitement (III) avec une cuve amovible (26), en ce qu'une partie inférieure de bacs (23) forme un tout qui reçoit les bacs (24, 25, 26) des trois zones de traitement (I, II, III), en ce que dans chacune des zones de traitement (I, II, III), les liquides de traitement sont appliqués sur la face supérieure et la face inférieure du matériau (14) à développer et en ce que le matériau est guidé en ligne droite à l'intérieur de chaque zone de traitement, dans la zone d'application du liquide de traitement considéré.

2. Machine de traitement selon la revendication 1, caractérisée en ce que deux fentes séparées (7, 8) d'entrée du matériau (14) sont prévues dans une partie supérieure de boîtier (3) de la machine de traitement (1) avec des tables d'entrée (4, 5) inclinées obliquement vers le bas, la première table d'entrée (4) acheminant le matériau à traiter vers une pré-chambre (I₀) située en amont de la première zone de traitement (I), et la deuxième table d'entrée (5) transportant le matériau vers une paire de rouleaux de déviation (51, 52) qui est située en amont d'une chambre d'application de liquide (53) dans la deuxième zone de traitement (II).

3. Machine de traitement selon la revendication 2, caractérisée en ce que la pente des première et deuxième tables d'entrée (4, 5) par rapport à l'horizontale est comprise entre 5° et 25°, en ce que la première table d'entrée (4) est articulée de manière à se rabattre sur la partie supérieure du boîtier (3) et en ce que la deuxième table d'entrée (5) est intégrée dans la partie supérieure de boîtier (3).

4. Machine de traitement selon la revendication 2, caractérisée en ce qu'une paire de rouleaux d'entrée (33, 34) est disposée dans la pré-chambre (I₀) et en ce que des ouvertures (28) pouvant être fermées sont ménagées dans une cloison (27) séparant la pré-chambre (I₀) et le bain de liquide de la première zone de traitement (I).

5. Machine de traitement selon la revendication 1, caractérisée en ce que la trajectoire (20) du matériau fait une courbe jusqu'au point le point le plus bas du bain de liquide dans la première zone de traitement (I) et en ce qu'à partir du point le plus bas, la trajectoire du matériau (20) est droite, inclinée obliquement vers le haut, jusqu'à l'extrémité de la première zone de traitement.

6. Machine de traitement selon la revendication 5, caractérisée en ce qu'un rouleau-brosse (40, 41) et son contre-rouleau (39; 42) associé sont disposés au-dessous et au-dessus de la trajectoire montante (20) du matériau, en ce que les rouleaux-brosses (40, 41) tournent à une vitesse différente de la vitesse d'acheminement du matériau et en ce qu'un couvercle (32) recouvre le bain de liquide entre une première paire de rouleaux de transport (35, 36) et le rouleau-brosse arrière (41), dans le sens de l'avance, y compris ce rouleau-brosse (41), de telle sorte qu'une aspiration de l'air par le rouleau-brosse est évitée.

7. Machine de traitement selon la revendication 6, caractérisée en ce que le couvercle (32) comporte une partie horizontale- (29) et une partie oblique (31), inclinée vers le haut et recouvrant les rouleaux-brosses (40, 41) et leurs contre-rouleaux (39, 42).

8. Machine de traitement selon la revendication 5, caractérisée en se que la partie inférieure de bacs (23) de la première zone de traitement (I) comporte, au-dessous des rouleaux-brosses (40, 41), dans le fond du bac, un dispositif de chauffage (30) qui comporte des canaux de refroidissement (75, 76) pour un refroidissement par eau.

9. Machine de traitement selon la revendication 8, caractérisée en ce que les canaux de refroidissement (75, 76) communiquent avec le bain de liquide contenu dans le bac (25) de la deuxième zone de traitement (II).

10. Machine de traitement selon les revendications 1 à 9, caractérisée en ce qu'il est prévu dans la deuxième zone de traitement (II), une chambre (53) d'application du liquide de traitement que traverse en son milieu et horizontalement la trajectoire (20) du matériau, en ce que dans la chambre d'application du liquide (53) se trouvent deux paires de tubes de vaporisation (60, 61; 62, 63) qui sont disposés à proximité de l'entrée et de la sortie de la trajectoire (20) de la chambre d'application du liquide (53) et en ce qu'une paire de rouleaux essoreurs (55, 56) est montée entre les deux paires de tubes de vaporisation (60, 61; 62, 63).

11. Machine de traitement selon la revendication 10, caractérisée en ce que l'un des tubes de vaporisation (60, 62 ou 61, 63) des deux paires est disposé au-dessous de la trajectoire (20) et l'autre des tubes de vaporisation des deux paires est disposé au-dessus de la trajectoire (20) et en ce que le rouleau essoreur (56) se trouvant sous la trajectoire (20) trempe dans le bain de liquide.

12. Machine de traitement selon la revendication 10, caractérisée en ce qu'une tubulure d'aspiration (71) d'une pompe (72) à commande électrique qui communique avec les tubes de vaporisation (60, 61, 62, 63) plonge dans le bain de liquide du bac (25) de la deuximème zone de traitement (II).

13. Machine de traitement selon la revendication 1, caractérisée en ce qu'elle comporte dans la troisième zone de traitement (III), au-dessus de la trajectoire (20), une rigole (64) sans buses pour l'application du liquide de traitement, qui a une section transversale en V avec des fentes (95) pratiquées le long du bord, dans la région de la trajectoire de passage du matériau et dans laquelle débouchent des tubes d'arrivée (74).

14. Machine de traitement selon la revendication 13, caractérisée en ce qu'elle comporte dans la troisième zone de traitement (III), après la rigole (64), au-dessous et au-dessus de la trajectoire (20) du matériau des rouleaux essoreurs (65, 66), le rouleau essoreur inférieur (66) pénétrant dans le bain de liquide de la cuve (26) et appliquant du liquide de traitement sur la face inférieure du matériau pendant le fonctionnement, et en ce que la cuve (26) recueille le liquide de traitement excédentaire s'écoulant des faces du matériau à travers la fente (95).

15. Machine de traitement selon la revendication 14, caractérisée en ce qu'une tubulure d'aspiration (69) d'une pompe (70) à commande électrique, pénètre dans le bac de liquide de la troisième zone de traitement (III), cette tubulure (69) communiquant avec le tube d'arrivée (74) pour remplir la rigole (64) de liquide de traitement, et en ce que la pompe (70) est disposée au-dessous de la partie inférieure de bacs (23).

16. Machine de traitement selon la revendication 15, caractérisée en ce que la cuve (26) comporte une décharge de fond (67) dans le bac de réserve de liquide de la troisième zone de traitement (III) et en ce qu'un bouchon (68) avec sortie (102) ferme la décharge de fond (67).

17. Machine de traitement selon la revendication 14, caractérisée en ce que plusieurs pompes (97, 97...) ou une seule pompe (98) sont montées dans le bain de liquide de la deuxième et de la troisième zones de traitement (II, III), en ce que chaque pompe (97) est reliée par une tringlerie et un excentrique (99) à un mécanisme d'entraînement des rouleaux des différentes paires de rouleaux, et en ce que les cotés pression des pompes (97; 98) de la deuxième et la troisième zones de traitement (II ou III) sont reliées aux tubes de vaporisation (60, 61, 62, 63) ou aux tubes d'arrivée (74) de la rigole (64).

18. Machine de traitement selon la revendication 15, caractérisée en ce que la cuve (26) comporte un orifice (96) dont la section transversale a une dimension telle que la quantité de liquide de traitement s'écoulant à travers cette ouverture (96) est inférieure à la quantité de liquide de traitement arrivant par la rigole (64).

19. Machine de traitement selon la revendication 17, caractérisée en ce que tous les rouleaux, à l'exception des rouleaux-brosses, tournent à une vitesse périphérique égale à la vitesse d'alimentation du matériau (14) à traiter et en ce que l'entraînement des pompes (97, 98) pour l'application des liquides de traitement est synchronisé avec l'entraînement des rouleaux et dérivé de celui-ci.

20. Machine de traitement selon les revendications 1 à 19, caractérisée en ce qu'elle comporte dans la partie inférieure de la machine (2) un ventilateur (19) dont le courant d'air (11) est guidé le long de la partie inférieure de bacs (23) et au-dessous de celle-ci, et sort, dirigé vers le haut, de la machine de traitement (1) par une fente de sortie d'air (12), à proximité d'une table de sortie (6) du matériau (14) à traiter.

21. Machine de traitement selon la revendication 20, caractérisée en ce que la table de sortie (6) comporte un évidement (13) s'étendant sur toute sa largeur, par lequel le courant d'air du ventilateur (19) s'écoule contre la face inférieure du matériau.

22. Machine de traitement selon la revendication 21, caractérisée en ce que la table de sortie (6) comporte pour le bord avant du matériel, une butée réglable (10), qui est placée de telle sorte que le bord arrière du matériau (14) vient reposer au-dessus de l'évidement (13).

23. Machine de traitement selon la revendication 10, caractérisée en ce que le rouleau de déviation inférieur (52) de la paire de rouleaux (51, 52) disposée dans la chambre d'application de liquide (53), trempe dans le bain de liquide de la chambre d'application de liquide (53).

Fig. 1

Fig. 1A

Fig. 2

# Fig. 3

**Fig. 4**

N-N'

**Fig.6**

Fig. 5

Fig.7

Fig.8